Europäisches Patentamt

European Patent Office

Office européen des brevets

(11) Publication number: **0 284 276**
**A2**

# EUROPEAN PATENT APPLICATION

(21) Application number: **88302259.2**

(22) Date of filing: **16.03.88**

(51) Int. Cl.⁴ **G11C 5/00**

(30) Priority: **16.03.87 US 25915**

(43) Date of publication of application:
**28.09.88 Bulletin 88/39**

(84) Designated Contracting States:
**AT BE CH DE FR GB IT LI LU NL SE**

(71) Applicant: **Stern, Donald S.**
**3170 Bimber Court**
**San Jose California 95148(US)**

(72) Inventor: **Stern, Donald S.**
**3170 Bimber Court**
**San Jose California 95148(US)**

(74) Representative: **Spence, Anne et al**
**Spence & Townsend Mill House Wandle**
**Road**
**Beddington Croydon Surrey CR0 4SD(GB)**

(54) Selective power gating.

(57) The invention is generally directed to a selective power gating device for providing power from a power supply to an electrical device adapted to receive at least two levels of power. A detection mechanism coupled to the electrical device determines a selected portion of the electrical device which requires a higher level of power. A power gating mechanism coupled to the detection mechanism and the power supply supplies a higher level of power to the selected portion and a lower level of power to a remaining portion of the electrical device. As a result, the overall power and heat generated by the electrical device is substantially reduced.

EP 0 284 276 A2

The invention is generally directed to the reduction of power consumption and prevention of heat build up in semi-conductive technology and specifically to the reduction in power consumption in prevention of heat build up in semiconductive technology by minimizing the actual power used in the semiconductor device or devices by selective power gating.

In a preferred embodiment of the invention selective power gating reduces the power consumption and prevents heat build up in semiconductive data storage technology by minimizing the actual power used to operate an array of semiconductor memory elements.

The first electronic memory devices relied on magnetic materials or vacuum tubes to store information. The magnetics were bulky, difficult to produce, and were slow to accept or recall information. The tubes, while faster, required a great deal of energy and produced an enormous amount of heat. As an answer to the problems presented by these technologies, semiconductor transistors ushered in a new wave.

The transistors consumed less energy then the previous tubes. The transistors produced less dissipated heat enabling them to be packed more closely, providing more memory in a smaller area. As the technology developed, smaller transistors could be produced to take advantage of these benefits. The build-up of heat still defined the limit to the number of transistors that could be contained in an area. In a quest to decrease the size of transistors and circuits, the integrated semiconductor device or chip was introduced.

Integrated circuits provided phenomenal reduction in the size of the components and a resultant increase in memory for a given area. New materials and techniques are continuously being developed to further the goals of making circuitry smaller, more energy efficient and less heat productive.

The evelation of electronic memory has been limited at each stage by the need to reduce the harmful build-up of heat which provided a barrier beyond which miniaturization could not proceed. This accumulation of heat has the effect of damaging circuitry and destroying the integrity of the information stored. While this rapid miniaturization of memory size has been most pronounced, similar attempts to reduce all electrical devices in size has progressed, with the heat generating problem acting as a restraining force to miniaturization.

One approach that has been utilized to cut down on the heat problem is the removal of the heat. Various methods have been used including aluminum heat sinks, gas or liquid filled cooling towers, fans, piping water near or within a chip, and immersion of the chip or electrical device in cooled or super-cooled liquids and gases. However, even with these approaches some devices still generate too much heat to be dissipated for reliable operation.

A second approach for coping with the heat problem has been to reduce the amount of heat created. Some methods used to do this have included development of low energy consumption micro-circuitry (such as CMOS), the use of pulsed or alternating current and the development of devices with low energy wait states or stand-by modes. Currently, the low energy wait states and stand-by modes are being used to allow for fluctuations in operating current and to aid in the graceful powering up of the circuitry.

With regard to memory devices, in common practice, the whole memory unit is powered up to an operating current for access, and when the electrical device is turned off the whole unit is powered down. This is particularly wasteful of power and generates relatively vast quantities of heat.

Briefly, the operation of a semiconductive memory element requires a small but measurable amount of power and generates a small but measurable amount of heat. When the memory elements are too densely packed, the heat accumulates and causes a loss of reliability. As progressively larger number of memory cells are placed together on a chip in greater concentrations the small quantities of heat generated by each component part is multiplied to an extent at which dangerous amounts of heat are produced.

Currently, large computers known as main frame computers generate such significant quantities of heat that the majority of the volume of a main frame computer's case is allocated to the cooling problem, includes fans, heat fins and other devices to assure acceptable temperature levels for required system reliability. Significant reductions in the heat generated by the circuitry would allow for the substantial miniaturization of main frame computers as well as other electrical devices. Such reduction in heat will lead to an ability to miniaturize and increase portability, decrease cost and expand the usefulness of the circuitry.

Accordingly, there is a need for an improved apparatus and method for reducing the power generated by electrical devices including memory devices, central processor units (CPU) and other devices to allow denser packing of circuitry, decreased cooling requirements, decreased power requirements and with regard to the memory, increased longevity, data reliability and increased portability of large capacity memory devices. The decrease in the consumption of power and generation of heat allows the physical size of an array of semiconductive memory elements to be reduced thus making the construction of electronic data storage devices with greater capacity, greater reliability, increased longevity and greater utility feasible for the first time.

## SUMMARY OF THE INVENTION

The invention is generally directed to a selective power gating device for providing power from a power supply to an electrical device adapted to receive at least two levels of power. A detection mechanism coupled to the electrical device determines a selected portion of the electrical device which requires a higher level of power. A power gating mechanism coupled to the detection mechanism and the power supply supplies a higher level of power to the selected portion and a lower level of power to a remaining portion of the electrical device. As a result, the overall power and heat generated by the electrical device is substantially reduced.

Accordingly, it is an object of the invention to provide an improved electrical device in which power consumed and heat generated are substantially reduced by selective power gating.

Another object of the invention is to minimize the actual power used to operate an array of semiconductive memory elements, and thus, by generating less heat, make it feasible to maintain the reliability of semiconductive memory elements in a more densely packed array.

A further object of the invention is to provide a selective power gating system in connection with an array of semiconductive memory elements to minimize the actual power used to operate the array of semiconductive memory elements, and thus, by generating less heat, make it feasible to maintain the reliability of the semiconductive memory elements in a more densely packed array.

Still another object of the invention is to provide selective power gating of semiconductive memory elements to decrease the consumption of power, generation of heat and physical size of an array of semiconductive memory elements so that it becomes feasible to build electronic data storage devices that have greater capacity, greater reliability, increased longevity and greater utility then previously possible.

Yet another object of the invention is to provide selective gating of power to provide operating power to specific circuitry only when that circuitry is to be used and placing that circuitry into an off state or lower energy wait state or stand-by state when not in use to reduce power consumption and heat generation in a device, that as a whole would not need to be maintained at full operating power at all times in order for the device to function properly.

Yet a further object of the invention is to provide selective gating of power in robots and android type devices to provide operating power to specific electronic functions only when the specific functions are to be performed and then turning off the operating power to the function or placing that function into a lower energy wait or stand-by state when it is not being performed.

Still a further object of the invention is to provide selective gating of power and means for reducing the power consumption and heat generation in computer systems including large mainframe computers by turning on specific circuits, CPUs and logical arrays when they are being used and then turning them off or placing them in a wait or stand-by state when they are not being used.

Yet another object of the invention is to provide reductions in heat and power requirements to enable production of small and portable products such as electronic clip boards, electronic books, portable and pocket computers and pocket or portable mainframe computers with greater memory capacities then previously possible.

Still a further object of the invention is to provide high density memory devices such as very high capacity static RAM devices that will replace existing mass storage devices such as laser disks, direct access storage devices (DASD), tape drives, floppy drives and hard drives.

Still other objects and advantages of the invention will in part be obvious and will in part be apparent from the specification.

The invention accordingly comprises the several steps and the relation of one or more of such steps with respect to each of the others, and the apparatus embodying features of construction, combination of elements and arrangement of parts which are adapted to effect such steps, all as exemplified in the following detailed disclosure, and the scope of the invention will be indicated in the claims.

## BRIEF DESCRIPTION OF THE DRAWINGS

For a fuller understanding of the invention, reference is had to the following description taken in connection with the accompanying drawings, in which:

Fig. 1 is a functional block diagram of a computer system constructed in accordance with the invention;

Fig. 2 is a partial functional block diagram of a volatile memory constructed in accordance with a preferred embodiment of the invention;

Fig. 3 is a partial functional block diagram of a non-volatile memory circuit constructed in accordance with the invention;

Fig. 4 is a partial functional block diagram of a Read Only Memory type memory circuit constructed in accordance with the invention;

Fig. 5 is a schematic diagramatic view of the manner in which various signals in the memory arrangement are controlled;

Fig. 6 is a functional block diagram of a memory array constructed in accordance with the invention; and

Fig. 7 is a functional block diagram of a computer system constructed in accordance with the invention.

## DETAILED DESCRIPTION OF THE PREFERRED EMBODIMENT

The purpose of the invention is to reduce the energy consumption and resultant heat accumulation in an electronic device. A preferred application is the use of semiconductor memory devices which are particularly suitable for use with the invention because of the manner in which activity is keyed to an address or groups of addresses. The invention is generally suitable for a variety of applications which will be described below although the primary description will be in context of a memory device.

Generally the technique used to accomplish the conservation of power is achieved by a selective power gating which turns the memory element or group of elements within an array off when not in use, only turning the memory element or group of elements within an array on immediately before use. The power line to each element or group of elements within an array will be turned on and off in sequence. First, the gates will be turned on prior to receipt of a read or write instruction. Then, the element or group of elements will be turned off after the read or write instruction is executed. Finally, any element or group of elements not in use are maintained in the off state. The on/off sequence is controlled by a special power gating circuit which insures appropriate timing and selection. The power gating circuit insures that power reaches the element or group of elements within an array before the signal to read or write reaches the element or group of elements. The power gating circuit also insures that power reaches only the particular element or group of elements within an array that are to be accessed.

## SELECTION

The power gating is determined by the address, which identifies the memory element or group of elements within an array that is to receive power. The address currently on the address bus activates the programmable array logic (hereafter "PAL") which in turn activates the power gate which then sends operating power to a memory element or group of elements to be accessed within an array. When another address is placed on the address bus or the address bus is cleared, the operating power is deselected. A PAL is a standard digital logic device which is programmed to recognize numbers, such as an address and initiate activity based on reception of appropriate addresses being input. The PAL is used to decode the address for purposes of operating the power gate which in turn controls the application of power to the memory blocks.

## SEQUENCING

The memory element or group of elements within the array must be powered up before a read or write enable signal is received from the central processor unit (CPU). Generally, the read or write enable signal is utilized to access a particular memory cell or array of cells in a computer memory. The read signal is indicative of data stored at a particular location being read out to the CPU. The write signal is representative of data being entered into the memory device from the CPU or other source within a system.

## TIMING

The timing between the address signal, the read or write signal and the data signal is managed by circuitry included for that purpose and/or through the action of the CPU. Examples of the circuitry which would delay the read or write signal an appropriate length of time are resistance circuits, delay buffers, latch buffering, path length adjustment and architecture of the memory element among others.

## OPERATING POWER ADDRESS DECODING

Operating power address decoding is accomplished through discrete components or programmable array logic which can be programmed to recognize the series of zeros and ones, such as memory block addresses, and in response will initiate another series of zeros and ones, such as an operating power gate select. The PAL in response to recognizing addresses placed on the address bus activates a gate that will cause the operating power voltage to travel to the designated block of memory within an array. Thus, in this type of system, only blocks of memory that are to be accessed receive operating power voltage.

## CONTROL LOGIC

Control logic is the standard means to provide logical addressing for the gating of read and write signals. Control logic can also be used to implement a delay in the read and write signals, if necessary for a particular type of memory element, to allow time for the operating power voltage to enable, such that the presence of valid data is assured on the data bus when read or write takes place. The use of buffers on the address bus, data bus and control bus is common when dealing with large amounts of memory. In this way, the integrity of the data is insured during the loading of the system's buses.

## NORMAL CYCLE

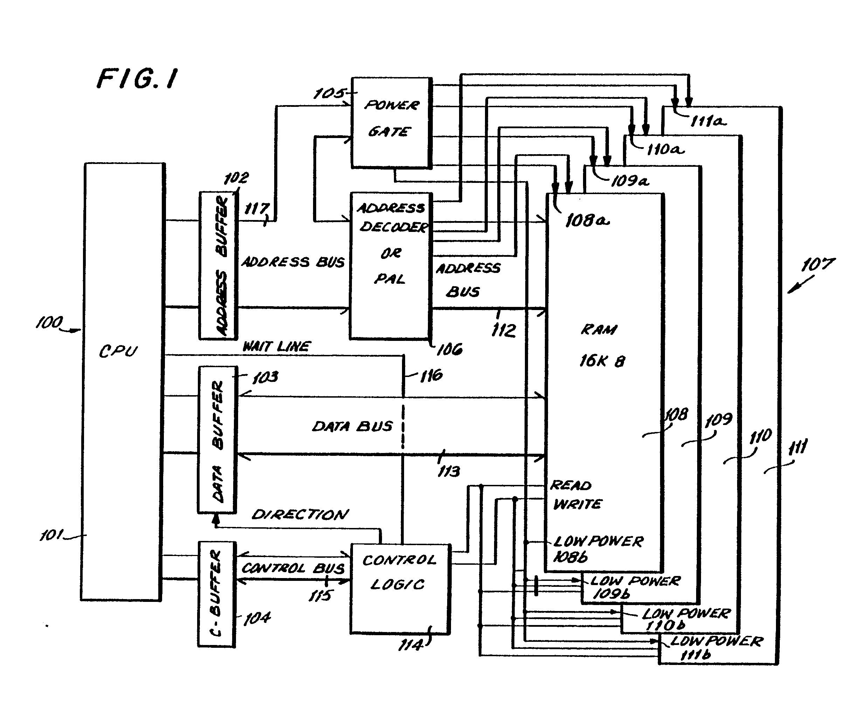

Reference is made to Fig. 1 for a brief overview of a normal cycle of operation of the selective power gating system in accordance with the invention. The computer system, generally indicated as 100 includes a CPU 101, address buffer 102, data buffer 103 and control buffer 104. A power gate 105 and PAL or address decoder 106 are coupled to address buffer 102 through an address bus 117. PAL 106 is coupled to memory array 107 shown as including 4 separate RAM chips 108, 109, 110 and 111 via an address bus 112 and at control terminals 108c, 109c, 110c and 111c respectively. Power gate 105 is coupled to each of memory chips 108, 109, 110 and 111 at high voltage inputs 108a, 109a, 110a and 111a and low power inputs 108b, 109b, 110b and 111b. The high power inputs 108a, 109a, 110a and 111a are used when the chip is to be in its on state and the low power inputs 108b, 109b, 110b and 111b are used when the memory chips are to be in their "off" state. The off state generally can require some voltage greater than zero to assure data integrity.

The data transmitted from CPU 101 through data buffer 103 is transmitted to memory array 107 via data bus 113. Data can also flow in the opposite direction from memory array 107 through data bus 113 and data buffer 103 to CPU 101. The direction of flow of data along data bus 113 is controlled by control logic 114 which is coupled to control buffer 104 through control bus 115. In addition, control logic 114 outputs a read or a write signal to an appropriate read or write input in memory array 107. Control logic 114 also may control the delay in outputting the read or write signal based on the known characteristics of the system and the known delay required for proper sequencing. In addition, as shown by wait line 116, CPU 101 may output a wait signal to the control logic 114 to control sequencing.

In general, a cycle will be initiated when a new address is placed on address bus 117. The address will be recognized by an address decoder or programmable array logic in power gate 105. The address decoder or programmable array logic in power gate 105 in turn will activate the power gate 105 associated with the specific block of data corresponding to the address (in Fig. 1, the block will be one of RAM chips 108, 109, 110 and 111). Alternatively, PAL 106 can be coupled to power gate 105 in place of the address bus connection to cause the selected RAM chip to receive its power from high power inputs 108a, 109a, 110a, 111a in place of the low power inputs 108b, 109b, 110b, 111b. In other contexts the memory blocks will be on a single chip with separate power supply inputs. Next, the selection of the read or write signal associated with the block or chip will be delayed slightly through software or hardwired logic; to allow the block to receive operating power before it is accessed. Then, either the read or the write signal will pass through to the memory element or group of elements which has been selected. The memory element or group of elements will then receive the read or write signal and deal appropriately with the data which will be on data bus 113 or output onto data bus 113. As soon as a new address is placed on address bus 107 or address bus 107 is cleared, the operating power to the memory or group of elements will be deselected by PAL 106 and power gate 105. When the memory elements are not being accessed they will be maintained at a lower power from low power inputs 108b, 109b, 110b and 111b (or no power depending upon the particular memory device utilized) than is typically required to operate the circuit but is sufficient to maintain the integrity of the stored data.

As noted above, the selective power gating approach may be utilized in a wide variety of different circuit arrangements with a wide variety of devices. In the memory context various types of memory elements. may be appropriately utilized with the selective power gating circuitry and approach. One area of application is volatile electronic memory which requires voltage to maintain the integrity of the stored information. As described above, the selective power gating provides operating power to specific memory elements to be accessed in an array through selective power gating during the read or write cycle and then returns these electronic memory elements to a lower energy-standby state which assures the maintenance of the stored information but utilizes less power. The selective power gating approach and circuitry may be utilized in connection with separate chips as shown in the embodiment of Fig. 1 or may be incorporated into a memory chip so that smaller groups of memory elements, down to a single memory cell level may be power selected or deselected.

The circuitry and method is also applicable to a non-volatile electronic memory which maintains data through a voltage potential supplied by a battery, capacitor or power cell. In this connection operating power is supplied to specific memory elements to be accessed in an array through selective power gating during the read or write cycle and the specific electronic memory elements are returned to the voltage potential state for data retention.

The selective power gating approach and circuitry is applicable to a read only memory (ROM, PROM, EPROM and EEPROM, for example) device. The read only memory devices do not require any voltage to maintain the integrity of the information. However, power is utilized in connection with accessing the data. In accordance with the selective power gating approach power may be provided to the specific memory elements which are to be accessed in an array through selective power gating circuitry during a read cycle and then ceasing the flow of power to the particular memory element after the cycle is completed.

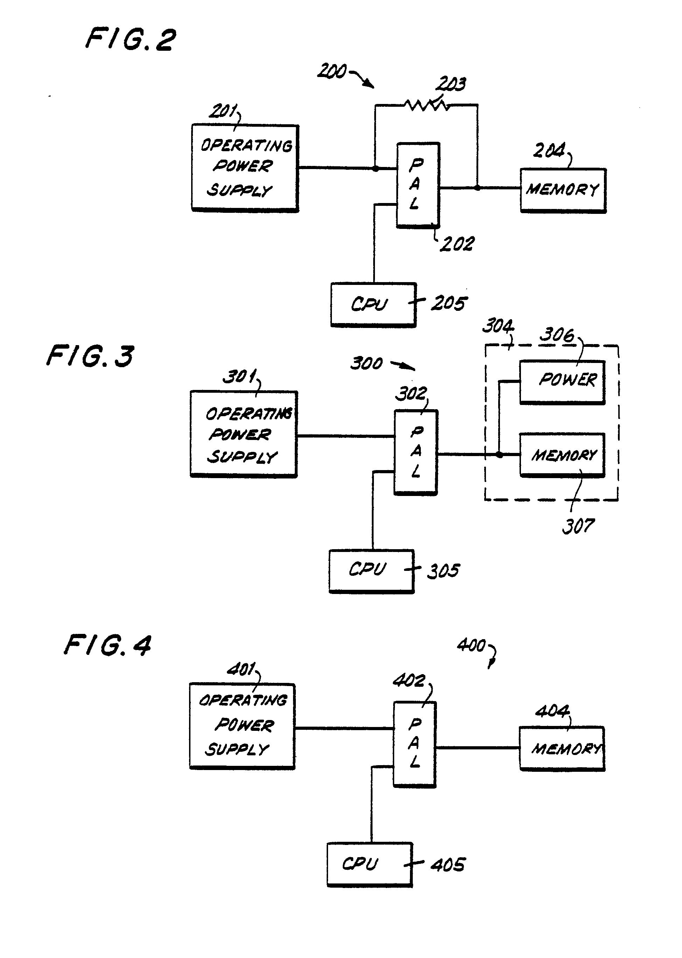

Reference is made to Fig. 2 wherein a partial functional block diagram of a volatile memory constructed in accordance with a preferred embodiment of the invention is depicted. In any volatile electronic memory having a standby power supply current or a low energy wait state, the operating power or supply current is selectively gated to a memory element or group of elements to be accessed. In the case of static random access memory, an array of chips can be maintained at the standby power supply current which is sufficient to retain data. As shown in Fig. 2, an operating power supply 201 is coupled to a PAL 202 and PAL 202 is coupled to a memory device or devices 204. A standby resistor 203 is connected between power supply 201 and the power input of memory or memories 204 to provide the standby power supply current for the lower energy wait state when PAL 202 prevents the operating power from being applied to memory 204. PAL 202 receives an address from CPU 205 which address is decoded in use to control the power supply function. The additional circuitry shown in Fig. 1 in connection with the power gate, control logic, buffers and buses for transporting the data to and from memory 204 have been excluded for ease of explanation rather than the PAL actually gating the power, this function could be generally performed by the power gate under the PAL'S control.

When a particular chip is to be accessed (that is read from or written to) it is identified by an address. This address activates a gate in PAL 202 which allows the operating power supply current to pass to that chip. After the chip is powered up it may then be read from or written to. After the chip is read from or written to, the operating power supply current is deselected, returning the chip to the standby power supply current.

There is a savings in power consumption, reduction in heat build up and lower power supply requirements because the remainder of the array of chips, while not be accessed, are kept at the standby power supply current. As shown in Fig. 2, the gate used to direct the operating power supply current may be a PAL chip programmed with the address representing the chip to be accessed. Other gates or switches are necessary to couple the read or write signal to the selected chip for the appropriate delay as described above.

One example of a static random access memory chip that can be used with the selective power gating approach is the Motorola MCM2016H 2048 $\times$ 8 bit static random access memory. The operating power supply current for this chip is 135mA while the standby current is merely 20mA. As a result, extremely substantial savings in power can be achieved by operating some or all of the memory chips in the system at the standby current rather than the operating power supply current. The selective power gate can be implemented through a PAL chip such as the CY8C322 chip or other commonly available PAL chips. The particular PAL chip used is dependent upon the particular application.

Reference is next made to Fig. 3 wherein a system, generally indicated as 300 constructed in accordance with the invention utilizing a non-volatile electronic memory is shown. The non-volatile electronic memory maintains data by retaining a voltage potential on the memory elements rather than by a kinetic flow of energy or current. System 300 includes an operating power supply 301 coupled to a PAL 302. PAL 302 is coupled to a memory device 304 which includes memory elements 307 and internal voltage potential or power source 306. PAL 302 is also coupled to CPU 305 so that addresses can be transmitted to PAL 302. As described above with regard to Fig. 2, much of the auxiliary circuitry shown in Fig. 1 has been excluded including the power gate for purposes of ease of explanation. The operating power supply 301 is gated through PAL 302 to memory 307. When CPU 305 sends an address to PAL 302, PAL 302 causes the operating power to be transmitted from operating power supply 301 to the appropriate memory element or elements. When a particular memory element or elements is not addressed it is maintained at the data retention voltage produced internally by power supply or voltage potential 306.

With non-volatile random access memories, an array of chips can be maintained at the data retention voltage by batteries, capacitors or power cells. When a particular chip is to be accessed (that is, read from or written to) it is identified by an address. This address activates a gate which allows the operating power supply current to pass to that chip. After the chip is powered up it may be read from or written to. Thereafter, when the chip has been read from or written to the operating power supply current is deselected by returning the chip to the data retention voltage.

There are significant savings in power consumption, reduction in heat build up and a lower power supply requirement because the remainder of the array of chips, while not being accessed, are kept at the data retention voltage.

The gate used to direct the operating power supply current may be a PAL chip programmed with the address as representing the chips to be accessed. As described above, with respect to Fig. 2, other gates or switches such as are shown in Fig. 1 are necessary to pass the read or write signal to the selected chip and at an appropriately delayed time period. In a preferred embodiment the non-volatile memory circuit can be implemented using a Greenwich Instruments GR328132K $\times$ 8 bit non-volatile RAM. This chip provides the data retention voltage through an on-board lithium power cell which provides the required voltage potential to keep the gates latched. In the preferred embodiment, the data retention voltage potential would be provided to an array of memory elements at one time by a capacitor or power cell. The CY8C322 PAL chip is appropriate for use in this embodiment although other PAL chips or discrete logic circuits are appropriately used.

As described above, the selective power gating approach and circuitry is applicable to read only memory, programmable read only memory and erasable programmable read only memory devices where data is maintained without power.

Reference is made to Fig. 4 wherein a selective power gating system, generally referred to as 400 constructed in accordance with the invention is depicted. Circuit 400 includes an operating power supply 401, PAL chip 402, memory 404 and CPU 405. In this approach power is applied to memory 404 only when necessary prior to accessing the memory. In this embodiment the data on the memory is retained without power. However, reduced heat build-up and lower energy requirements are realized by the selective gating of power.

The invention postulates various logical devices which can be used to implement the purposes of the power selection gate. One implementation involves the use of equivalent logical electronic elements instead of the programmable array logic. Another implementation involves the use of switches external to the logical components to provide passage of the power signal. Various different methods of sequencing and timing of the relative signals to allow the address to activate the power selection gate before a read signal, write signal or enable signal reaches the semiconductive memory are possible. Specific examples include buffering, such as latch buffering and inverter buffering, timing derived through the CPU and other techniques involving capacitors or channel path length delays.

Further savings in energy consumption can be achieved through the use of pulsed current or alternating current for the operational and standby power supplies. This further reduces the energy and heat in the system. The selective power gating arrangement can use tie-down currents on all address, data, signal and power lines as a means of insuring path readiness and more consistant current requirements and as a part of a mass erasure scheme. Variations in the addressing scheme may also be utilized to reduce power in accordance with the selective power gating approach. Specifically, the address scheme may have an inversion or mapping of the bit assignments on the address path as a method of distributing the physical access of logically sequential semiconductive memory elements (such as in memory interweave). This is particularly useful in high speed memories such as are used in cache memory systems as a means of parallel accessing. In addition, latch buffering can be utilized to extend the width of the address and/or data path. Other variations in the addressing scheme include use of mapping schemes such as virtual addressing, whereby a logical address may not correspond to the physical address of the semiconductive memory element and redundant addressing schemes for the assurance of component reliability and their integrity. The semiconductor memory elements may be mounted in any manner. Examples of known methods are printed circuit boards, surface mounting, substrate or water mounting techniques and package mountings.

The selective power gating apparatus method can be utilized in connection with various cooling techniques. Examples include the use of liquids, gases or solids to remove heat from the area of the semiconductive memory element and super-cooled components wherein the cooling is essential to the operation of the memory element.

The selective power gating approach is not tied to any particular semiconductor memory elements or technology. The approach is applicable semi-

conductive elements formed from amorphous silicon, gallium arsenide, thin-film deposition techniques, crystal and growth techniques and specifically the dense-packing techniques of semiconductor memory elements that the selective power gating enables.

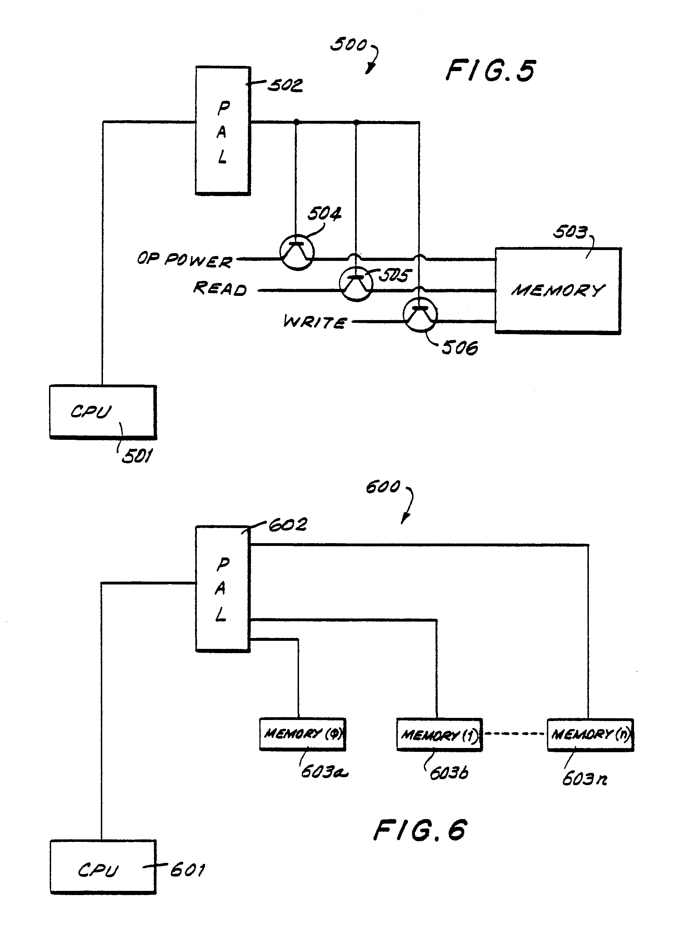

The selective power gating approach is applicable to all devices capable of producing addresses that can activate a power selection gate. In the context of a memory device the selective power gating postulates the use of Read, Write, Enable or Select signals in conjunction with the power selection gate. Fig. 5 shows a circuit generally indicated as 500 depicting the control of various signals based on an address transmitted from CPU 501 to PAL 502 and the gating of operational power, read signals and write signals by gates 504, 505 and 506, respectively to memory 503.

The selective power gating identifies the need in some conventional semiconductor memory elements to provide gating of the read signal, write signal and enable signals to prevent their activating a memory element in the low energy state and thereby corrupting the data therein contained. Fig. 5 is one expedient for dealing with this potential problem. These corrupting signals can be used positively as part of a mass erasure or security - scheme as well.

The selective power gating approach is also appropriate for the management of signals to more than one semiconductor memory element under the control of a logical controller such as a programmable array logic device.

Reference is made to Fig. 6 wherein a circuit 600 constructed in accordance with the invention including a CPU 601, PAL 602 and memory 603a, 603b, ... 603n are provided. In this embodiment a single PAL 602 controls many different memories, the different memories may be physically separate such as in different chips or may be separated by an internal mapping scheme on a chip incorporating the PAL or separate from the PAL.

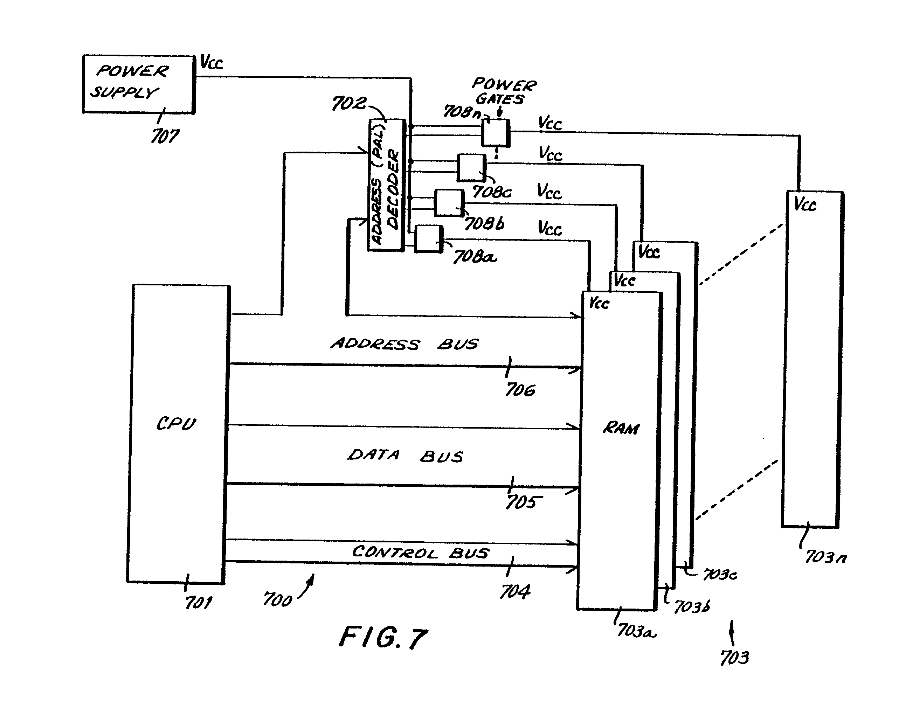

Reference is next made to Fig. 7 wherein a computer system constructed in accordance with a preferred embodiment of the invention, generally indicated as 700 is depicted. Computer system 700 includes a CPU 701, a address decoder or PAL 702, memory 703 including separate RAM chips 703a, 703b, 703c ...703n, a power supply 707 and power gates 708a, 708b, 708c ... 708n corresponding in number to the RAM chips. A control bus 704 and a data bus 705 connect CPU 701 and memory 703. An address bus couples CPU 701 to PAL 702 and memory 703. PAL 702 controls the application of operating voltage $V_{cc}$ from power supply 707 to memory chip 703a, 703b, 703c ... 703n through power gates 708a, 708b, 708c ... 708n. In this way, PAL 702 and power gates 708a-708n control the selective application of power to each of the memory chips 703a-703n.

The selective gating of power can be used to provide operating power to specific circuitry only when that circuitry is to be used and then placing that circuitry into an off state or lower energy wait state or standby state when not in use to reduce the power consumption and heat generation in any device. The approach is appropriate for use in any device that does not need to be maintained at full operating power at all times in order for the device to function properly.

Selective gating of power in robots and android type devices provide operating power to specific electronic functions only when those specific functions are to be performed and in turning off the operating power to the function or the placing of that function to a lower energy wait state or standby state when it is not being performed is also desirable.

A selective gating of power as a means of reducing power consumption heat generation in computer systems is also applicable to large mainframe computers. Specific circuits, CPUs and logical arrays can be turned on as they are to be used and then turned off while placed into a wait state or standby state when they are not being used. This is particularly necessary in very high speed computers which traditionally generate considerable heat. In fact, many large mainframe computers have a large percentage of their volume consumed by cooling apparatus including heat fins and fans.

Selective power gating allows for the production of small and portable products with significantly greater memory capacity then previously possible. Various products such as electronic clip boards, electronic books, portable and pocket computers and pocket mainframe computers are achievable and viable with the reductions in size available due to the increased densities possible due to the heat reduction achieved.

Selective power gating enables the creation of extremely high capacity static RAMS that can replace existing mass storage devices such as laser disks, direct access storage devices (DASD), tape drives, floppy disk drives and hard disk drives. The selective power gating also supplants or replaces present electronic semiconductor memory in many applications. The selective power gating enables the production of cartridges or cards that can replace a storage medium such as a floppy diskette, magnetic tape or laser disk. Further, the selective power gating approach can serve to enable several cooling and super-cooling technologies opening up the possibility of virtually unlimited memory capacity devices.

The selective power gating is also useful in providing memory of sufficient capacity to fully automate hospitals, industries and government agencies. The increase in memory capacity and circuit complexity enabled by the selective power gating approach will also enable the production of robots and the creation of synthetic brains.

Circuitry including selective power gating will enable products dependent on the circuitry to serve as substitutes for paper, publications, books, magazines and newspapers and serve in medical instruments and implants where minimization of heat is particularly critical. The selective power gating approach may be used in three dimensional imaging, such as holographic telephone and three dimensional laser projectors for the entertainment, defense and medical industries made possible by the large capacity and high speed of the memories enabled by the invention. Products dependent upon the invention can also be incorporated into common objects, such as appliances, tools, toys, lights, jewelry and vehicles. Products dependent on the invention can also be incorporated into common objects such as cups, shoes, clothing, walls and other inert objects to provide an intelligent environment for the operation of robots and community management systems. Products utilizing the invention can also be used in place of photographic film and paper, audio and video recorders and film. New developments dependent upon the advances of this invention will have applications in the defense, medical and entertainment industries that will effect substantial change in the storage and use of information.

It will thus be seen that the objects set forth above, among those made apparent from the preceding description, are efficiently attained and, since certain changes may be made in carrying out the above method and in the constructions set forth without departing from the spirit and scope of the invention, it is intended that all matter contained in the above description and shown in the accompanying drawings shall be interpreted as illustrative and not in a limiting sense.

## Claims

1. A selective power gating device for providing power from a power supply to an electrical device adapted to receive at least two levels of power, comprising:

detection means coupled to the electrical device. for determining a selected portion of the electrical device requiring a higher level of power; and

power gating means coupled to the detection means, electrical device and the power supply means for supplying the higher level of power to the selected portion and a lower level of power to a remaining portion;

whereby overall power consumption of the electrical device is reduced.

2. A selective power gating device for providing power from a power supply means to a memory device, the memory device being coupleable to an external device for reading or writing, comprising: the memory device including at least two blocks, each block including control circuitry and memory circuitry, each block being adapted to receive power at each of at least two levels of power, a higher active level and a lower retention level required to maintain data in a block;

means for applying the lower retention level of power to all of the blocks;

detection means coupled to the external device for identifying a selected block of the memory device requiring a higher level of power; and

power gating means coupled to the detection means and the power supply means for normally preventing the supply of the higher active level of power to the blocks and selectively supplying the higher level of power to the identified block when required for operation of the block of the memory device;

whereby each of the at least two of the blocks is normally powered at the lower retention level of power except when the higher active level of power is required so that overall power consumption of the memory device is reduced.

3. A selective power gating computer system, comprising:

memory means for storing information, said memory means having at least two memory portions, each of which is adapted to separately receive two different power levels, a higher operating power level and a lower data retention power level required to maintain the integrity of the data in the memory portion;

processing means coupled to the memory means for controlling data processing and the movement of data at least one of to and from the memory means;

power supply means adapted to supply power at the higher operating power level and the lower data retention power level to the memory means;

detection means coupled to the processing means for identifying a selected memory portion of the memory means requiring the higher operating power level; and

power gating means coupled to the power supply means, detection means and memory means for normally preventing the supply of the higher operating power level to the memory portions while not preventing the supply of the lower retention level of power to those of the at least two memory portions not identified by the detection means, and selectively supplying the higher operating power level to the identified selected memory portion of the memory means when required for operation of the selected memory portion;

whereby the power consumption of the memory means is reduced.

4. A selective power gating device for providing power from a power supply means to a memory device, the memory device being coupleable to an external device for reading or writing, comprising:

the memory device including at least two blocks, each block including control circuitry and memory circuitry, the memory circuitry for each block being adapted to receive each of at least two levels of power, a higher active level and a lower retention level required to maintain data in a block;

means for applying the lower retention level of power to the memory circuitry of all of the blocks;

detection means coupled to the external device for identifying a selected block of the memory device requiring the higher active level of power; and

power gating means coupled to the detection means and the power supply means for normally preventing the supply of the higher active level of power to memory circuitry of the blocks while not preventing the supply of the lower retention level of power to at least the memory circuitry of the at least two blocks not identified by the detection means, and selectively supplying the higher active level of power to the memory circuitry of the identified selected block;

whereby each of the at least two blocks has its memory circuitry powered at the lower retention level of power except when the higher active level of power is required so that overall power consumption of the memory device is reduced.

5. A selective power gating device for providing power from a power supply means to a memory device, the memory device being coupleable to an external device for reading or writing, comprising:

the memory device including at least two blocks, each block including control circuitry and memory circuitry, the control and memory circuitry for each block being adapted to receive at least two levels of power, a higher active level and a lower level, said lower level being either a no power level or a retention level of power required to maintain data in a block;

detection means coupled to the external device for identifying from the output of the external device a selected block of the memory device requiring the higher active level of power; and

power gating means coupled to the detection means and the power supply means for normally preventing the supply of the higher active level of power to the control and memory circuitry of the blocks while not preventing the supply of a lower retention level of power to at least the memory circuitry of the at least two blocks not identified by the detection means, and selectively supplying the higher active level of power to the control and memory circuitry of the identified block;

whereby the control and memory circuitry of each of the two blocks is powered to the active level of power only when required so that overall power consumption of the memory device is reduced.

6. The selective power gating device of claim 5, wherein the higher level of power corresponds to operating power required for at least one of reading from or writing to the memory device.

7. The selective power dating device of claim 5, wherein the detection means includes an address decoder coupled to the external device to receive addresses associated with each block which identify the block requiring the higher active level of power.

8. The selective power gating device of claim 5, wherein the detection means includes a programmable array logic device coupled to the external device to receive addresses associated with each block which identify the block requiring the higher active level of power.

9. The selective power gating device of claim 5, further including delay means for delaying the memory device from receiving a read or write instruction until the power gating means supplies the higher level of power to the selected block.

FIG.1

0 284 276

FIG.2

FIG.3

FIG.4

# FIG.5

500

502 — P A L

504
OP POWER

505
READ

WRITE
506

503
MEMORY

CPU
501

# FIG.6

600

602 — P A L

MEMORY (φ)
603a

MEMORY (1)
603b

MEMORY (n)
603n

CPU — 601

FIG.7